**Europäisches Patentamt**

**European Patent Office**

**Office européen des brevets**

(11) Numéro de publication : **0 296 997 B1**

(12) **FASCICULE DE BREVET EUROPEEN**

(45) Date de publication du fascicule du brevet :
19.08.92 Bulletin 92/34

(51) Int. Cl.⁵ : **H01L 29/78, H01L 27/08**

(21) Numéro de dépôt : **88420206.0**

(22) Date de dépôt : **21.06.88**

(54) **Structure de transistors MOS de puissance.**

(30) Priorité : **22.06.87 FR 8709157**

(43) Date de publication de la demande :
**28.12.88 Bulletin 88/52**

(45) Mention de la délivrance du brevet :
**19.08.92 Bulletin 92/34**

(84) Etats contractants désignés :
**BE DE FR GB IT NL**

(56) Documents cités :
**EP-A- 0 132 861**
**EP-A- 0 179 693**
**DE-A- 3 046 749**
**GB-A- 2 098 799**
**US-A- 4 589 004**

(73) Titulaire : **SGS-THOMSON
MICROELECTRONICS S.A.
7, Avenue Galliéni
F-94250 Gentilly (FR)**

(72) Inventeur : **Tonnel, Eugène
6 Impasse Bérivière
F-38240 Meylan (FR)**
Inventeur : **Thomas, Gilles
6 Rue Rif Tronchard
F-38120 Fontanil Cornillon (FR)**

(74) Mandataire : **de Beaumont, Michel et al
1bis, rue Champollion
F-38000 Grenoble (FR)**

EP 0 296 997 B1

## Description

La présente invention concerne les transistors MOS de puissance et notamment des structures de transistors MOS à effet de champ complémentaires et leur procédé de fabrication. De telles structures de transistors à effet de champ complémentaires sont généralement désignées dans la technique par l'appellation CMOS (complémentaire-métal-oxyde-semiconducteur).

La présente invention vise plus particulièrement une telle structure pouvant supporter des tensions relativement élevées de l'ordre de quelques centaines de volts.

L'intégration de tels éléments de commande de puissance est de plus en plus utilisée dans des circuits intégrés d'interface qui associent des composants de puissance isolés de type CMOS et des structures logiques également de type CMOS.

On connait maintenant diverses structures de transistors MOS permettant de supporter des tensions élevées. Dans le cas de la réalisation de MOS de puissance, pour que ces structures puissent laisser passer des courants importants, on est amené à mettre en parallèle un très grand nombre (par exemple de l'ordre de $10^4$ à $10^6$) de transistors élémentaires.

Ainsi, sur un circuit intégré, on cherchera par exemple à réaliser dans une première partie de la surface un circuit logique, dans une deuxième partie un transistor MOS de puissance d'un premier type, par exemple à canal N, et dans une troisième partie un transistor MOS de puissance d'un deuxième type, c'est-à-dire à canal P, ces deux transistors de puissance étant constitués d'un grand nombre de transistors identiques en parallèle.

Pour les mises en parallèle des transistors, il faut interconnecter leurs grilles, leurs sources et leurs drains, respectivement, ces diverses zones se trouvant sur une même surface d'une tranche semiconductrice.

Etant donné que la plupart des technologies de fabrication de circuits intégrés n'utilisent que deux niveaux de couches de connexion, des problèmes topologiques et dimensionels se posaient pour arriver à interconnecter entre eux toutes les grilles, toutes les sources et tous les drains sans réaliser de court-circuit. Ainsi, on a été amené dans l'art antérieur à utiliser des structures dans lesquelles, certaines de ces connexions, par exemple les drains, sont connectées selon des sous-groupes par l'intermédiaire de zones à haut niveau de dopage prévues dans le substrat semiconducteur (souvent des couches enterrées). De telles structures sont décrit en EP-A- 0 132 861. Mais, de telles connexions sont inévitablement plus résistives que les couches de connexion réalisées au dessus du substrat semiconducteur, par exemple, du silicium polycristallin dopé, des siliciures ou des métallisations. On a corrélativement été amené à développer des structures dites interdigitées, c'est-à-dire dans lesquelles des électrodes en forme de doigts ou de dents de peigne, de source et de drain, respectivement, s'enchevêtrent pour venir contacter les zones de source et de drain respectives. Là aussi, la nécessité de prévoir des doigts de grande longueur entraine des résistances d'accès relativement importantes.

De telles résistances d'accès importantes vers la grille, la source ou le drain nuisent à la rapidité de fonctionnement du dispositif et obligent à prévoir des connexions d'une certaine dimension pour éviter les échauffements.

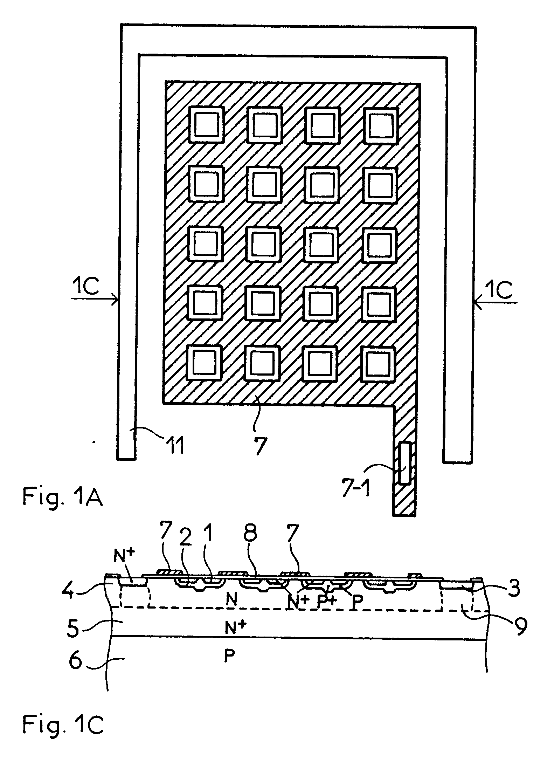

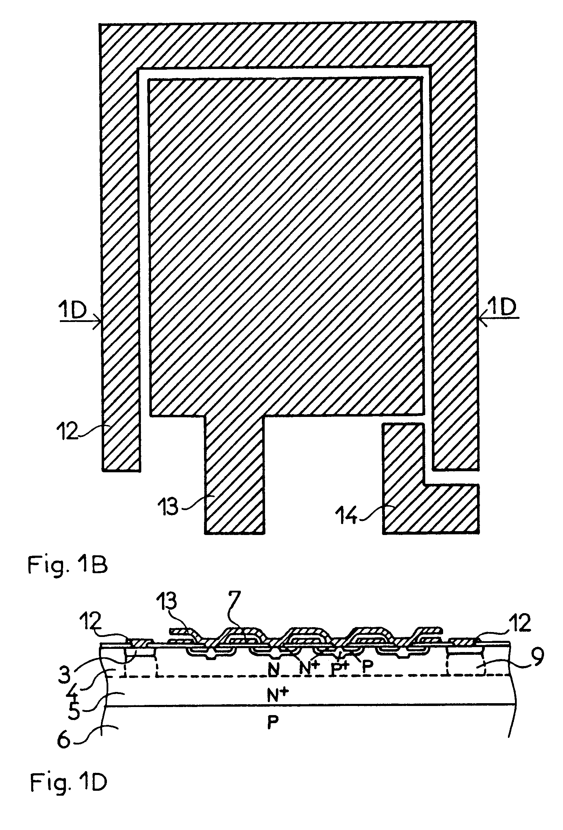

Un exemple de structure de l'art antérieur va être décrit en relation avec les figures 1A à 1D parmi lesquelles les figures 1A et 1B représentent une vue de dessus d'une structure d'électrodes adoptée dans le cas où l'on dispose de deux niveaux de métallisation pour assurer les connexions de grilles, de sources et de drains, les figures 1C et 1D représentant des vues en coupe correspondantes.

En considérant d'abord la vue en coupe de la figure 1C, on peut y voir des transistors de type DMOS, c'est-à-dire MOS Diffusé, à canal N, comprenant des régions de sources 1, des couches 2 dans lesquelles doivent être formés les canaux, et des régions de drains 3. Cette structure est formée dans une couche épitaxiée 4 de type N en dessous de laquelle se trouve une zone enterrée 5 de type $N^+$ formée sur un substrat 6 de type P. La conduction se fait, quand une polarisation est appliquée sur des électrodes de grille 7 reposant sur une couche d'oxyde de grille 8, depuis les régions de source 1 à travers les régions de canal vers la couche enterrée 5 de type $N^+$ puis en remontant vers les zones de drain 3. Eventuellement, des diffusions profondes de type $N^+$ 9 assurent une meilleure conduction entre les zones de drain 3 et la couche enterrée 5.

Cette structure est uniquement représentée comme un exemple de nombreuses structures de transistors MOS de puissance pouvant être utilisées.

Si l'on considère plus particulièrement la réalisation des électrodes, on forme dans un premier niveau de connexion une électrode de grille 7 illustrée en figure 1A. Ensuite, on dépose sur cette couche conductrice une couche isolante, par exemple une couche de $SiO_2$, qui est ouverte aux emplacements représentés en figure 1A par des carrés sur les régions de source à l'intérieur des mailles de l'électrode de grille, par des doigts allongés 11 sur des régions de drain et par des ouvertures localisées 7-1 à la périphérie de l'électrode de grille 7. Après cela, comme le représente la figure 1B, un deuxième niveau d'interconnexion est déposé et gravé pour fournir une métallisation de drain 12 en forme de doigt allongé, une métallisation de source 13 établissant le contact avec toutes les surfaces supérieures des sources à l'intérieur des ouvertures dans l'électrode de grille de premier niveau, et une métallisation de reprise de grille 14. La figure 1D représente une vue en coupe de la figure 1B où l'on voit les deux niveaux d'interconnexion et où de mêmes couches que dans les autres figures sont désignées par de mêmes références.

On peut voir que ces structures amènent à une dissymétrie entre les électrodes de source et de drain. La conduction vers les drains se fait par l'intermédiaire de la couche enterrée 5 et l'électrode de drain 12 est digitée. On tente d'assurer une compensation dans la conduction en ajustant la largeur de la connexion de drain mais on se trouve néanmoins avec des structures dissymétriques pour la source et le drain. Ceci n'est pas favorable à la propagation de courants importants ce qui est l'un des objectifs quand on veut réaliser des transistors de puissance.

D'autre part, si l'on veut réaliser des structures groupant comme on l'a indiqué précédemment un très grand nombre de transistors en parallèle, par exemple de $10^4$ à $10^6$, pour ne pas avoir des doigts de drain trop longs, on met en parallèle plusieurs structures telles que représentées en figures 1A et 1B en prévoyant une digitation importante des électrodes.

Avec la progression des technologies de fabrication des circuits intégrés, on arrive maintenant à réaliser de façon contrôlée des structures à trois niveaux de métallisation. Néanmoins, en raison de la force de l'habitude, on n'a pas pour autant abandonné les structures digitées de l'art antérieur et l'on trouve toujours des structures de transistors MOS en parallèle dans lesquelles des sources sont regroupées par sous-ensembles et des digitations importantes sont utilisées sur les drains. La troisième couche d'interconnexion est utilisée pour augmenter l'épaisseur de certains niveaux de métallisation ou bien pour reprendre des contacts croisés sur des doigts de source et de drain et améliorer ainsi la structure maillée du réseau d'électrodes pour réduire les résistances d'accès.

Ainsi, un objet de la présente invention est de prévoir une nouvelle structure d'interconnexion à trois niveaux pour des transistors MOS de puissance en parallèle permettant une réduction générale de la résistance d'accès aux grilles, sources et drains et l'obtention d'une structure symétrique source/drain.

Un autre objet de la présente invention est de prévoir une nouvelle structure de transistor MOS de puissance particulièrement adaptée au mode de connexion réalisé selon le premier objet de l'invention.

Un autre objet de la présente invention est de prévoir des structures de transistors MOS à canal P et N, respectivement, adaptées au mode de connexion selon l'invention et compatibles entre elles.

Pour atteindre ces objets, la présente invention prévoit une structure de transistors MOS de puissance en parallèle dont chacun comprend, sur une même face d'un substrat, des zones de de grille, de source et de drain et trois niveaux de couches de connexion, un premier niveau de couche de connexion établissant un contact avec toutes les grilles et une liaison entre chaque grille et les grilles adjacentes, ce premier niveau de couche de connexion comprenant des ouvertures au dessus des zones de contact de source et de drain ; cette structure comprend en outre une première couche d'isolement ouverte au dessus des zones de contact de source et de drain, un deuxième niveau de couche de connexion établissant un contact avec toutes les zones de source ou de drain et une liaison entre chaque zone de source (ou de drain) et les zones de source (ou de drain) adjacentes, des ouvertures isolant chaque contact de drain (ou de source), une deuxième couche d'isolement ouverte au dessus des zones de drain (ou de source), un troisième niveau de couche de connexion continu établissant un contact avec toutes les zones de drain (ou de source) du deuxième niveau de couche de connexion.

Selon un mode de réalisation de la présente invention, le premier niveau de couche de connexion comprend du silicium polycristallin et un siliciure et les deuxième et troisième niveaux de couches de connexion comprennent des métallisations.

Selon un mode de réalisation de la présente invention, il est prévu des structures de transistors MOS complémentaires dont chacun est constitué d'une structure de transistor telle qu'énoncée précédemment et dans lesquelles, sur les MOS d'un premier type, la deuxième couche de connexion est associée aux sources et, sur les MOS du deuxième type, la deuxième couche de connexion est associée aux drains.

Une structure de transistors à effet de champ complémentaires particulièrement adaptée à la présente invention comprend un transistor à canal N latéral de type DMOS et un transistor à canal P latéral de type à drain étendu, dans laquelle, dans le N DMOS, la zone de canal est séparée de la zone de drain par une zone d'oxyde de champ et, dans le P MOS, l'extension du drain est formée sous une zone d'oxyde de champ.

Selon un mode de réalisation, le dopage de la zone d'extension de drain du P MOS résulte d'une implantation réalisée de façon autoalignée avant la croissance de l'oxyde de champ.

Ces objets, caractéristiques et avantages ainsi que d'autres de la présente invention seront exposés plus en détails dans la description suivante d'un mode de réalisation particulier faite en relation avec les figures jointes parmi lesquelles :

les figures 1A à 1D destinées à illustrer l'état de la technique et à faire ressortir les avantages de la présente invention ont été décrites précédemment ;

Les figures 2A, 2B et 2C représentent des vues de dessus de premier, deuxième et troisième niveaux d'interconnexion selon la présente invention ;

la figure 3 représente une vue en coupe d'une structure de transistor DMOS à canal N particulièrement adaptée à la présente invention ; et

la figure 4 représente une structure de transistor MOS à canal P à drain étendu particulièrement adaptée à la présente invention et compatible avec la structure de transistor à canal N illustrée en figure 3 pour former avec celle-ci des transistors MOS complémentaires.

De façon générale, et comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

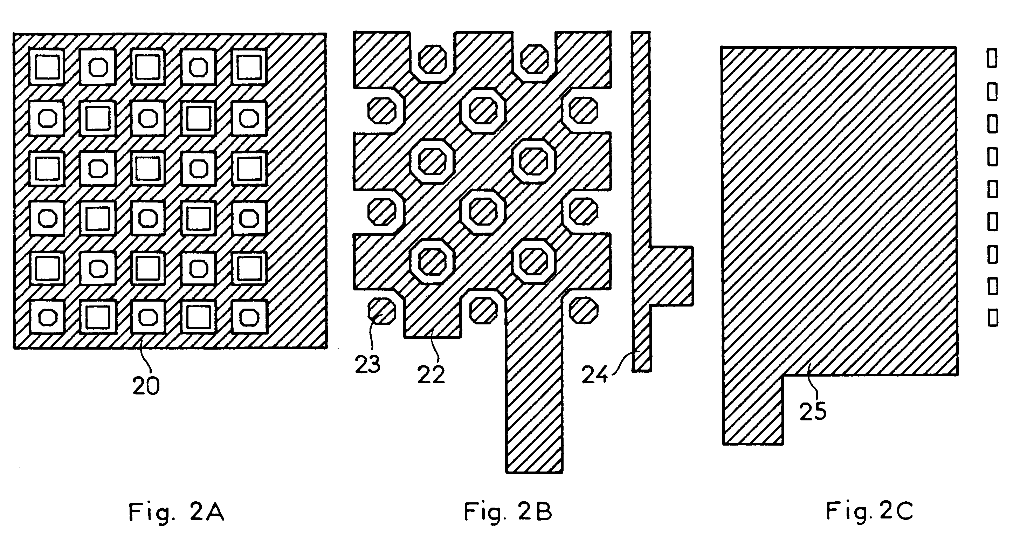

Les vues de dessus des figures 2A, 2B et 2C seront mieux comprises ultérieurement à la lecture de la description d'exemples de transitors MOS adaptés à la présente invention. Néanmoins, il suffit dans un premier temps de concevoir que l'on a réalisé dans un substrat semiconducteur des transistors MOS en parallèle dont chacun comprend côte à côte une zone de drain et une zone de source sensiblement de mêmes surfaces séparées par une zone de grille. Ainsi, en vue de dessus, les zones de drain et de source sont alternées comme les cases noires et blanches d'un échiquier, les zones de grille correspondant aux limites entre ces cases de l'échiquier mais ayant bien évidemment une largeur non nulle.

Ainsi, la figure 2A représente un premier niveau de métallisation 20 dans lequel on a réalisé seulement l'électrode de grille pour établir une structure ayant simplement la forme d'un quadrillage. Des ouvertures sont ménagées dans l'électrode de grille, ces ouvertures permettant de voir alternativement une zone de drain et une zone de source. Ce premier niveau de métallisation 20 est ensuite recouvert d'une couche d'isolement qui est elle-même ouverte à l'intérieur des cases encerclées par les zones de grille. Bien que l'on ait utilisé le terme "métallisation", ce premier niveau de connexion pourra être une couche de silicium polycristallin éventuellement recouverte d'une couche de siliciure métallique ou partiellement ou totalement transformée en un siliciure métallique ou encore être un métal réfractaire.

La figure 2B représente un deuxième niveau de métallisation qui vient en contact avec les surfaces découvertes des zones de source et de drain. Ensuite, cette couche de métallisation est gravée comme cela est représenté dans la figure pour laisser en place :

– une métallisation de source 22 venant en contact avec toutes les surfaces découvertes de source et assurant une liaison avec chaque métallisation de source adjacente ;

– des métallisations de drain 23 venant en contact avec chaque surface de drain découverte mais isolées des métallisations de source et des autres métallisations de drain ;

– une métallisation 24 venant en contact avec la métallisation de grille du premier niveau représentée en figure 2A et préalablement découverte à l'emplacement approprié.

Ensuite une couche d'isolement est déposée uniformément sur la surface de la tranche telle que représentée à la figure 2B. Des ouvertures sont formées au niveau de chacune des métallisations de drain 23 et au niveau des connexions de sortie des électrodes de grille et de source ; et un troisième niveau de métallisation uniforme 25 tel qu'illustré en figure 2C est déposé pour interconnecter entre eux tous les drains et pour assurer la sortie des électrodes de grille et de source.

Comme on le notera ci-après, il conviendra éventuellement dans la structure ci-dessus d'inverser les termes drain et source sans modifier la structure elle-même.

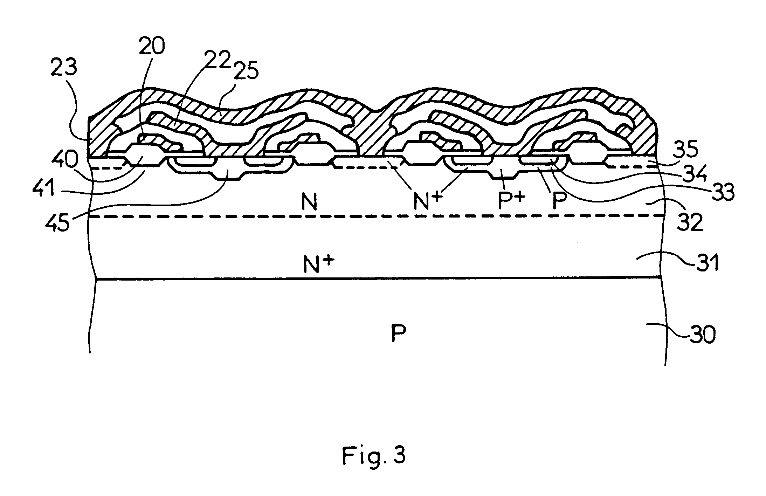

La figure 3 représente une vue en coupe d'une portion d'un groupe de transistors MOS de type N et parallèle particulièrement adaptés à une application selon la présente invention. Les métallisations sont désignées par les mêmes références qu'en figure 2.

Cette structure comprend un substrat 30 de type P, une couche enterrée 31 de type $N^+$ commune à toute la structure de transistors MOS de type N en parallèle mais isolée par rapport aux couches enterrées correspondantes des autres transistors MOS existant sur la même tranche, et une couche épitaxiée de type N 32. Les transistors MOS comprennent des régions de canal 33, de source 34 et de drain 35. La région de canal 33 et la région de source 34 étant deux zones successivement diffusées dans la couche épitaxiée 32, cette structure est désignée par l'expression MOS à canal diffusé ou DMOS.

La structure particulière de la figure 3 présente par rapport à une structure DMOS de puissance classique les spécificités suivantes :

– Des zones d'oxyde de champ 40 séparent la zone de canal proprement dite en dessous des grilles 20 des zones de drain proprement dites 35, c'est-à-dire que le drain comprend d'une part la région 35 fortement dopée, d'autre part une région 41 située sous lesdites zones d'oxyde de champ, de même dopage de type N mais à plus faible concentration. La région 41 peut résulter d'une implantation réalisée avant croissance des zones d'oxyde de champ 40 et peut donc être autoalignée avec ces zones d'oxyde de champ en utilisant le même masque que celui qui servira à délimiter les zones d'oxyde de champ.

– La région 33, couramment appelée région de canal car c'est dans une partie superficielle de cette région disposée sous la grille 20 que se forme le canal, présente une structure particulière. D'une part, elle comprend une zone de diffusion P délimitée par le bord des ouvertures gravées dans l'électrode de grille 20, d'autre part, de façon centrale, est prévue une région 45 de type P$^+$ qui remonte jusqu'à la surface du substrat de sorte que l'électrode de source 22 établit un contact d'une part avec la région de source 34, d'autre part avec cette région de type P$^+$ 45. On réalise ainsi un court-circuit source-canal.

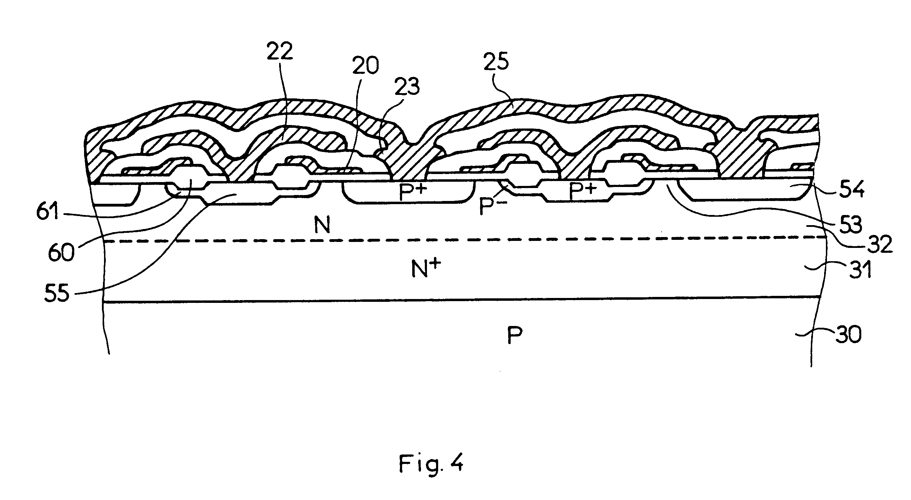

La figure 4 représente une vue en coupe d'une portion d'un groupe de transistors MOS à canal P particulièrement adaptée à la disposition d'électrodes selon la présente invention et en outre compatible du point de vue de sa fabrication avec la structure de transistor DMOS à canal N décrite précédemment.

On retrouve en figure 4 le substrat 30 de type P, la couche enterrée de type N$^+$ 31 commune à tous les transistors PMOS en parallèle, et la couche épitaxiée de type N 32. Dans cette couche épitaxiée, chaque transistor comprend des zones de canal 53, de source 54 et de drain 55.

Ce transistor est du type à canal composite, également appelé à drain étendu. Il présente les spécificités suivantes :

– la zone de drain 55 de type P$^+$ est cernée par une maille d'oxyde de champ 60 sous laquelle s'étendent des prolongements 61 de la zone de drain, également de type P mais plus faiblement dopés que la zone de drain de type P$^+$ proprement dite. Ces extensions du drain sont désignées par la référence 61.

– Comme dans le cas de la structure de la figure 3, on notera que ces zones d'extension de drain 61 sous les zones d'oxyde de champ 60 peuvent être formées de façon autoalignée avec les mailles d'oxyde de champ 60 en prévoyant une implantation délimitée par le même masque que celui qui sert à délimiter les zones d'oxyde de champ.

En figure 4 les divers niveaux de métallisation sont désignés par des références numériques identiques à celles des figures 2 et 3. On notera toutefois, que le deuxième niveau de métallisation 22, 23 qui, en figure 3, correspond aux métallisations de sources et aux prises de contact de drains respectivement, correspond en figure 4, aux métallisations de drains et aux prises de contact de sources. De même le troisième niveau de métallisation 25 qui, en figure 3, est une métallisation de drain correspond, en figure 4, à une métallisation de source. Cette inversion n'est pas le fait du hasard mais est particulièrement intéressante dans le cas de transistors MOS à drain étendu pour assurer la stablité et le champ minimum à la surface du transistor. En effet, l'effet conjugué des potentiels appliqués à la surface de la tranche semiconductrice par les métallisations de source et de drain permet d'assurer un étalement des lignes de champ par formation d'un écran de champ au desus de zones limites de drain et donc de permettre une plus haute tenue en tension.

Les avantages de la combinaison des structures particulières de transistor DMOS à canal N et de transistor MOS à drain étendu à canal P telles que décrites en figures 3 et 4 ressortira mieux de la description suivante d'un mode de fabrication simultané de ces transistors, d'où il ressort que ces deux transistors peuvent être fabriqués simultanément en utilisant un minimum d'étapes de fabrication, la plupart de ces étapes étant communes à la formation d'un élément dans chacune des structures.

Les étapes principales sont les suivantes :

1. Formation de couches enterrées 31 de type N$^+$ par implantation et diffusion d'arsenic (As - $4 \times 10^{15}$ Acm$^{-2}$, 100 keV) dans un substrat 30 de type P d'une résistivité de 14 à 20 ohms.cm et d'orientation (100).

2. Formation de fondations d'isolement - Une implantation de bore d'une dose de $4 \times 10^{14}$ Acm$^{-2}$ avec une énergie de 180 keV peut être utilisée. Ces fondations d'isolement (non représentées) de type P$^+$ sont destinées, en liaison avec des diffusions P descendantes à isoler des caissons dans lesquels pourront être formés des structures MOS logiques.

3. Dépôt par épitaxie d'une couche 32 de silicium de type N ; les caractéristiques de cette couche sont choisies en fonction de la tenue en tension requise pour les transistors MOS de puissance. Des épaisseurs variables comprises entre 10 et 30 micromètres et des résistivités allant de 1 à 15 ohms.cm peuvent être employées pour réaliser des composants dont la tension de fonctionnement variera de 60 à 500 V.

4. Formation des drains N$^+$ profonds des MOS de type N et des diffusions de type P rejoignant les fondations mentionnées au point 2. Les drains sont réalisés par diffusion à partir d'une source de phosphore, les zones de type P par implantation de bore ($10^{13}$ Acm$^{-2}$), le traitement de diffusion pouvant être conduit simultanément à température élevée (1220°C par exemple durant 4 à 6 heures).

5. Les caissons P étant ainsi formés, la réalisation des éléments actifs peut être entreprise.

La réalisation des transistors MOS est du type à oxydation de champ localisée par nitrure, et à implantation de champ auto-alignée, les implantations de champ sont réalisés avec du bore à $10^{13}$ Acm$^{-2}$ pour les champs P et de l'arsenic $5 \times 10^{12}$ Acm$^{-2}$ pour les champs N. Ces implantations sont effectuées dans des régions qui seront oxydées ultérieurement pour former des régions d'oxyde thermique SiO$_2$ épais (environ 1 micromètre), régions non couvertes par le nitrure.

Ces régions d'implantation formeront soit les régions de champ d'une partie CMOS logique, soit les canaux composites, ou extensions de drain (61) des transistors MOS tel celui représenté en figure 4. Cette utilisation à de multiples fins des implantations de champ constitue un aspect de la présente invention.

6. Le nitrure protégeant les régions actives est alors retiré, l'oxydation de grille effectuée, sur une épaisseur de 50 à 100 nm, et la couche de silicium polycristallin 20 déposée et dopée pour former le premier niveau de connexion.

7. La gravure des électrodes de grille des différents types de transistors MOS est alors effectuée simultanément. Des sélections successives permettent de doper par implantation : le canal 33 du DMOS avec du bore ($2$ à $6 \times 10^{13}$ Acm$^{-2}$) ; les régions P$^+$, de drain 55 et de source 54, des MOS P et de courts-circuits 45 des DMOS avec du bore ($5$ à $8 \times 10^{14}$ Acm$^{-2}$) ; et enfin les régions N$^+$ formant les drains et sources des DMOS (pour ce faire une dose d'arsenic de $5$ à $7 \times 10^{15}$ Acm$^{-2}$ peut être utilisée). Ces différentes implantations sont suivies de traitements thermiques appropriés de façon à restaurer les défauts et à obtenir les profondeurs de jonction optimales. Des profondeurs typiques de 1 à 1,5 micromètre pour les régions N$^+$ et P$^+$ permettent d'obtenir des transistors de puissance performants.

Le dopage des régions actives intervenant après la gravure des électrodes de grille dans la couche de silicium polycristallin, il est possible d'aligner les différentes régions sur le bord de ces électrodes. En particulier, il est possible de réduire la dimension de la cellule élémentaire du DMOS, en alignant la région P$^+$ formant le court-circuit de source sur le bord de l'électrode de grille (figure 3).

De la même façon, l'alignement de l'extension de drain sous l'oxyde épais permet d'éliminer les écarts de positionnement et de réduire la dimension de l'extension de drain à la valeur requise pour supporter latéralement la tension nécessaire.

On obtiendra donc dans l'un et l'autre cas une réduction sensible de la surface nécessaire et donc une meilleure utilisation du silicium.

8. En ce qui concerne les métallisations des deuxième et troisième niveaux de connexion, elles peuvent être réalisées par les opérations successives suivantes :

– dépôt d'une couche d'isolement sur l'électrode de grille 20 ;

– gravure d'ouvertures dans cette couche mettant le silicium à nu ;

– dépôt d'une couche de métal et gravure des interconnexions. On obtiendra par exemple dans le cas du DMOS de puissance à canal N une électrode de source 22 formée d'un réseau maillé et des pastilles isolées 23 sur les drains de chaque MOS élémentaire ;

– dépôt d'une couche isolante et ouverture de passages au niveau des pastilles 23 réservées précédemment sur chaque drain. Cette opération peut nécessiter plusieurs dépôts et attaques successifs par gravure sèche, de façon à obtenir une couche d'isolement suffisamment plane pour permettre un isolement et franchissement convenable de la deuxième couche de métal ;

– dépôt de la deuxième couche de métal et gravure des électrodes de drain 25.

Dans la réalisation proposée à titre d'exemple, les électrodes métalliques sont gravées dans des couches d'aluminium dopées avec du silicium et du cuivre et les couches de diélectriques obtenues par dépôt de SiO$_2$ par voie chimique en phase vapeur (CVD) dopé avec du phosphore. Des couches composites TiW-Al avec des contacts du type siliciure (Pt-Si) ont également été utilisées avec succès.

La structure de MOS de puissance intégré selon l'invention se caractérise par les points suivants :

1. Structure multicouche du type réseau maillé interconnectant les grilles, drains et sources des cellules composées par les MOS élémentaires.

2. Structure d'électrodes planes permettant de couvrir la totalité de la surface active du transistor de puissance ainsi formé.

3. Utilisation de la même opération (implantation dite de champ) pour contrôler les transistors MOS parasites dits de champ, et les régions dites de drain étendu des transistors MOS haute tension de puissance.

4. Ordre de la séquence de réalisation des différentes opérations de dopage.

Les avantages de la structure et du procédé mis en oeuvre sont alors les suivants :

1. Résistance minimum entre deux cellules élémentaires quelconques des transistors MOS haute tension de puissance.

2. Tenue en tension et stabilité maximum des transistors MOS haute tension.

3. Structure de densité maximum obenue par le procédé d'auto-alignement rendu possible par l'ordre adopté pour les opérations de dopage.

En revenant sur les divers niveaux de connexion, les principales caractéristiques des électrodes sont les suivantes :

- elles forment dans trois plans distincts un réseau maillé d'interconnexions des régions de grille, source et drain des différentes cellules élémentaires ;

- chaque plan d'interconnexion est isolé du suivant par une couche diélectrique dont l'épaisseur peut être ajustée en fonction des caractéristiques recherchées.

Cette configuration confère à l'assemblage des cellules élémentaires les propriétés électriques intéressantes suivantes :

- obtention de la résistance minimum entre les électrodes équivalentes, grille, drain ou source, de deux cellules élémentaires quelle que soit leur disposition dans la nappe constituant le transistor de puissance ;

- couverture de la surface totale du dispositif par l'ensemble des électrodes : cette disposition permet de faire jouer aux électrodes de drain et de source le rôle d'écran électrostatique. Elle est particulièrement intéressante dans le cas de transistors MOS à drain étendu pour assurer la stabilité et le champ minimum à la surface du transistor ; la recherche de l'effet d'écran optimum implique dans le cas représenté en figure 2 d'inverser l'ordre dans lequel les interconnexions des sources et des drains sont réalisées : on connectera en effet les électrodes de source au niveau 2 et celles de drain au niveau 3 dans le cas d'un DMOS à canal N, alors qu'on adoptera l'ordre inverse dans le cas du MOS à canal P, le drain étant cette fois connecté au niveau 2 et la source au niveau 3. Dans les deux cas, l'électrode de grille en silicium polycristallin est réalisée en premier et constitue le niveau 1 ; elle peut être connectée soit avec le niveau 2, soit avec le niveau 3, les plots nécessaires à la soudure des connexions au boîtier étant toujours réalisés dans la dernière couche de métallisation ;

  - cette disposition particulière d'électrodes multi-couches permet en ajustant les épaisseurs des diélectriques qui les isolent d'obtenir un effet graduel d'écran de champ et une tenue en tension maximum des transistors MOS des deux types.

## Revendications

1. Structure de transistors MOS de puissance en parallèle dont chacun comprend sur une même face d'un substrat des zones de contact de grille, de source et de drain et trois niveaux de couches de connexion, un premier niveau de couche de connexion (20) établissant un contact avec toutes les grilles et une liaison entre chaque grille et les grilles adjacentes, ce premier niveau de couche de connexion comprenant des ouvertures au dessus des zones de contact de source et de drain, caractérisée en ce qu'elle comprend en outre :
  − une première couche d'isolement ouverte au dessus des zones de contact de source et de drain,
  − un deuxième niveau de couche de connexion établissant un contact avec toutes les zones de source (22) et de drain (23) et une liaison entre chaque zone de source (ou de drain) et les zones de source (ou de drain) adjacentes, des ouvertures isolant chaque contact de drain (ou de source),
  − une deuxième couche d'isolement ouverte au dessus des zones de drain (ou de source),
  − un troisième niveau de couche de connexion (25) continu au dessus des première et deuxième couches établissant un contact avec toutes les zones de drain (ou de source) du deuxième niveau de couche de connexion.

2. Structure de transistor MOS selon la revendication 1, caractérisée en ce que le premier niveau de couche de connexion comprend du silicium polycristallin et un siliciure et les deuxième et troisième niveaux de couche de connexion comprennent des métallisations.

3. Structure de transistors MOS complémentaires dont chacun est constitué d'une structure selon la revendication 1, caractérisée en ce que, sur les MOS d'un premier type, la deuxième couche de connexion est associée aux sources et en ce que, sur les MOS du deuxième type, la deuxième couche de connexion est associée aux drains.

4. Structure de transistors MOS complémentaires (CMOS) pour circuit intégré monolithique selon la revendication 3, comprenant un transistor à canal N latéral de type DMOS et un transistor à canal P latéral de type à drain étendu, caractérisée en ce que, dans le N DMOS, la zone de canal (33) est séparée de la zone de drain (35) par une zone d'oxyde de champ (40) et en ce que, dans le P MOS, l'extension du drain (61) est formée sous une zone d'oxyde de champ (60).

5. Structure de transistors MOS complémentaires selon la revendication 4, caractérisée en ce que le dopage de la zone d'extension de drain (61) du P MOS résulte d'une implantation réalisée de façon autoalignée avant la croissance de l'oxyde de champ (60).

## Patentansprüche

1. Anordnung paralleler MOS-Leistungstransistoren, von denen jeder auf der gleichen Seite eines Substrats Gate-, Source- und Drainkontaktbereiche und drei Ebenen von Verbindungsschichten aufweist, wobei eine erste Verbindungsschichtebene (20) einen Kontakt mit allen Gates und eine Verbindung zwischen jedem Gate und den angrenzenden Gates bildet sowie Öffnungen über den Source- und Drainkontaktbereichen aufweist, gekennzeichnet durch
  − eine erste über den Source- und Drainkontaktbereichen offene Isolationsschicht,
  − eine zweite Verbindungsschichtebene, die einen Kontakt mit allen Sourcebereichen (22) und Drainbereichen (23) und eine Verbindung zwischen jedem Source-(oder Drain-)bereich und den angrenzenden Source-(oder Drain-)bereichen bildet, wobei Öffnungen jeden Drain-(oder Source-)kontakt isolieren,
  − eine zweite über den Drain-(oder Source-)bereichen offene Isolationsschicht,
  − eine dritte kontinuierliche Verbindungsschichtebene (25) über der ersten und der zweiten Schicht, die einen Kontakt mit allen Drain-(oder Source-)bereichen der zweiten Verbindungsschichtebene aufbaut.

2. MOS-Transistorenanordnung nach Anspruch

7

1, dadurch gekennzeichnet, daß die erste Verbindungsschichtebene ein polykrislallines Silicium und ein Silicid aufwveist und die zweite und die dritte Verbindungsschichtebene Metallisierungen aufweisen.

3. Anordnung komplementärer MOS-Transistoren, wobei jeder Transistor eine Anordnung nach Anspruch 1 aufweist, dadurch gekennzeichnet, daß bei den MOS-Transistoren einer ersten Art die zweite Verbindungsschicht mit den Sources gekoppelt ist und bei den MOS-Transistoren der zweiten Art die zweite Verbindungsschicht mit den Drains gekoppelt ist.

4. Anordnung komplementärer MOS-Transistoren (CMOS) für einen monolitischen integrierten Schaltkreis nach Anspruch 3, mit einem DMOS Seiten-N-Kanaltransistor und einem Seiten-P-Kanaltransistor mit erweitertem Drain, dadurch gekennzeichnet, daß beim N-DMOS der Kanalbereich (33) vom Drainbereich (35) durch einen Feldoxidbereich (40) getrennt ist und beim P-MOS die Drainerweiterung (61) unter einem Feldoxidbereich (60) ausgebildet ist.

5. Anordnung komplementärer MOS-Transistoren nach Anspruch 4, dadurch gekennzeichnet, daß sich die Dotierung des Drainerweiterungbereiches (61) des P-MOS aus einer Implantation ergibt, die gemäß automatischer Ausrichtung vor dem Wachsen des Feldoxids (60) ausgeführt ist.

## Claims

1. A structure of parallel power MOS transistors, each of which comprises, on a same face of a substrate, gate, source and drain contact zones and three levels of connection layers, a first level of connection layer (20) establishing a contact with all the gates and a connection between each gate and the adjacent gates, this first level of connection layer comprising openings above the source and drain contact regions, characterized in that it further comprises:

    – a first insulation layer opened over the source and drain contact regions,
    – a second connection layer level establishing a contact with all the source region (22) and drain regions (23) and a connection between each source (or drain) region and the adjacent source (or drain) regions, apertures insulating each drain (or source) contact,
    – a second insulation layer opened over the drain (or source) regions,
    – a third continuous connection layer level (25) above said first and second layers establishing a contact with all the drain (or source) regions of the second connection layer level.

2. A MOS transistor structure according to claim 1, characterized in that the first connection layer level comprises polysilicon and a silicide and the second and third connection layer levels comprise metallizations.

3. A complementary MOS transistor structure, wherein each transistor is made of a structure according to claim 1, characterized in that, on the MOS transistors of a first type, the second connection layer is associated with the sources and, on the MOS transistors of the second type, the second connection layer is associated with the drains.

4. A complementary MOS transistor (CMOS) structure in a monolithic integrated circuit according to claim 3, comprising a DMOS type lateral N-Channel transistor and an extended type lateral P-channel transistor, characterized in that, in the N DMOS, the channel region (33) is separated from the drain region (35) by a field oxide layer (40) and wherein, in the P MOS, the drain extension (61) is formed under a fields oxide region (60).

5. A complementary MOS transistor structure according to claim 4, characterized in that the doping of the drain extension region (61) of the P MOS results from an implantation carried out in a self-aligned way before the growing of the field oxide (60).

Fig. 1A

Fig. 1C

Fig. 1B

Fig. 1D

Fig. 2A   Fig. 2B   Fig. 2C

EP 0 296 997 B1

Fig. 3

EP 0 296 997 B1

Fig. 4